Europäisches Patentamt

European Patent Office

Office européen des brevets

(11) Publication number: **0 464 917 A1**

# EUROPEAN PATENT APPLICATION

(21) Application number: **91201613.6**

(22) Date of filing: **25.06.91**

(51) Int. Cl.5: **H01J 37/244**

(30) Priority: **03.07.90 NL 9001512**

(43) Date of publication of application:
**08.01.92 Bulletin 92/02**

(84) Designated Contracting States:
**DE FR GB**

(71) Applicant: **N.V. Philips' Gloeilampenfabrieken**
**Groenewoudseweg 1**
**NL-5621 BA Eindhoven(NL)**

(72) Inventor: **van der Ven, Robert Franciscus**
**Laurentius**
**c/o INT. OCTROOIBUREAU B.V. Prof.**
**Holstlaan 6**
**NL-5656 AA Eindhoven(NL)**

(74) Representative: **Zwaan, Andries Willem et al**
**INTERNATIONAAL OCTROOIBUREAU B.V.**
**Prof. Holstlaan 6**
**NL-5656 AA Eindhoven(NL)**

(54) Electron beam apparatus for topographical detection.

(57) The electron beam apparatus 1 includes a specimen holder 5 incorporated in a specimen chamber 3 and an electron source 11 for generating a primary electron beam 13. By interaction of the primary electron beam 13 and a specimen 9, secondary electrons (SE) and backscattered electrons (BSE) 19 are generated. The electron beam apparatus 1 further includes a detection sytem 20 for detecting the two signals and for processing them into a topographical image. The detection system 20 is arranged for simultaneously detecting the SE-signal and the BSE-signal using one and the same detector 21, the signal processing being effected on-line.

The invention relates to an electron beam apparatus including a specimen holder accommodated in a specimen chamber, an electron beam for generating a primary electron beam, by which by interaction with a specimen secondary electrons (SE) and backscattered electrons (BSE) are generable and a detection system for detection and processing of both the secondary electron signal and the backscattered electron signal to form a topographical image. The invention also relates to a method of detecting and processing SE-signals and BSE-signals to provide topographical information of a specimen.

An electron beam apparatus can, for example, be an electron beam writing device or an electron microscope, in which a topographical detection system can be incorporated, both the SE and the BSE contributing towards the formation of a topographical image.

Such an electron microscope, in this case a scanning electron microscope, is decribed in the publication by B. Volbert in Philips Electron Optics Bulletin 121(1980) pages 29-35. In this publication a fraction a of a BSE-signal detected by a Multi-Function-Detector producing a BSE-intermediate image, is subtracted from a SE-signal detected by a laterally arranged Everhart-Thornley detector, which produces a SE-intermediate signal. This mixed signal SE-a.BSE provides a well-contrasted topographical image.

This method has however the disadvantage that it is necessary to store temporarily both a SE-intermediate image and a BSE-intermediate signal. Thereafter, the fraction a of the BSE-signal, which effectively contributes towars the topography must be determined. The BSE-signal namely contains a great deal of depth information which disturbs the topography. If the complete BSE-signal is subtracted from the SE-signal, unwanted shadow effects are produced. This, results in a complicated and time-consuming method. In addition, during the signal processing operation, image distortions may occur due to positional inaccuracies of the two detectors relative to each other.

The invention has for its object to simplify the detection and the processing of the signals of an at least qualitatively equivalent topographical image. To that end, the invention is characterized, in that the detection system is arranged for the simultaneous detection of the SE-signal and the BSE-signal, using the same detector. Image distortion due to the relative positions of the detectors is now obviated, since all the information is supplied by one detector.

A preferred embodiment of the electron beam apparatus of the invention is characterized, in that, the detection system is arranged for on-line processing of the SE-signal and the BSE-signal. Image storage is not required, so that the two signals can directiy be processed into a final image with a minimum of loss of time.

A further preferred embodiment of the electron beam apparatus in accordance with the invention, is characterized, in that, a detector for detecting both the SE-signal and the BSE-signal is in a BSE-detection position. The SE can be influenced more easily by detection than the BSE. The energy of the BSE is, namely, of the order as the energy of the primary electrons, which consequently would automatically be influenced too.

A further preferred embodiment of the electron beam apparatus of the invention is characterized, in that, the detector can be adjusted to a higher potential for detection of SE. SE are usually employed for separating BSE deflected to a laterally arranged detector. Since the SE have a low energy, they can easily be deflected after they have left the specimen. By raising the detector to an increased voltage, the SE are accelerated in the direction of the detector. In contrast thereto, the fast BSE are little influenced thereby.

A preferred embodiment of the electron beam apparatus in accordance with the invention, is characterized, in that, a first end of the detector, which end faces the specimen, has two phosphor layers, a first phosphor layer of which emits light at a first wavelength and a second phosphor layer emits light at a second wavelength. The detector voltage is controlled such that the SE have sufficient energy to excite the first phosphor layer they meet, taken in the direction away from the specimen, but not the second, whereas the BSE because of their energy penetrate into the second phosphor layer and also excite this layer, which is most remote from the specimen. Thus light of two different wavelengths is generated. The use of two phosphor layers for the detection of electrons having different energies is known *per se* from US-A 3,517,243.

A further preferred embodiment of the electron beam apparatus in accordance with the invention, is characterized, in that, a second end of the detector, facing away from the specimen, includes a light-splitting element for separating the different wavelengths to be detected, light beams having different colours being incident on different ligh-sensitive meters. The light originating from the phosphors, can, for example, be conveyed *via* a flexible optical conductor to a light-splitting element which spatially separates the different wavelengths. It is then sufficient to place light-sensitive meters in the different exit directions to register the quantity of light of each wavelength. The use of flexible optical conductors with detectors of this type is known *per se* from EP 0,018,031.

A further preferred embodiment of the electron beam apparatus in accordance with the invention, is characterized, in that, the detection system includes a plurality of detectors arranged symmetrically relative to the optical axis.

In principle it is sufficient to provide one detector, which detects both signals. Since the detecor has been raised to an increased voltage to be capable of detecting the SE, the field between the specimen and the detector might become inhomogeneous and have a negative effect on the electron beams to be detected and the primary electron beams. By arranging the detectors symmetrically relative to the optical axis, this negative effect is prevented and signals of a better quality can be obtained. The method in accordance with the invention, is characterized, in that, both signals can be simultaneously detected by one and the same detector, be separated from each other and processed on-line.

Since one detector is sufficient for the detection of two signals, positional inaccuracies which may occur when each signal were detected by a different detector need not to be taken into account. Since the signals can be processed on-line, storing intermediate images has become superfluous, so that less storage capacity is required and the processing operation is faster.

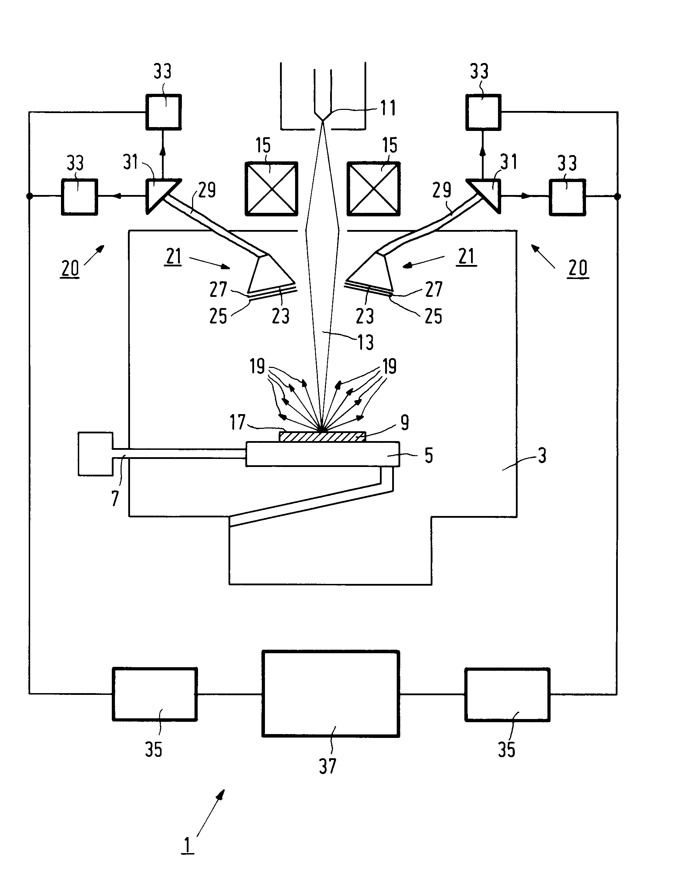

The invention will now be described in greater detail with reference to the accompanying drawing.

The sole Figure of the drawing is a schematical representation of an embodiment of the electron beam apparatus of the invention.

The electron beam apparatus 1 includes a specimen holder 5 which is incorporated in a specimen chamber 3 and can be operated by, for example, an arm 7 from outside the specimen chamber 3. An electric control of the specimen holder 5 is also possible. A specimen 9 is located in the specimen holder 5. In addition, the electron beam apparatus 1 includes an electron source 11 for generating a primary electron beam 13. The primary electron beam 13 is focused by a lens system 15 onto the specimen 9. During the interaction between the primary electron beam 13 and the specimen 9 secondary electrons and backscattered electrons are *inter alia* generated, which is illustrated by the arrows 19. The electron beam apparatus 1 further includes a plurality of detectors 21, which are each capable of recording both the SE-signal and the BSE-signal simultaneously. The first end 23 of the detectors 21, which faces the specimen 9, is provided with two phosphor layers 25, 27, which are each excited by electrons having different energies. The detectors 21 are raised to a higher voltage level, the SE then being accelerated such that they will more specifically excite the first phosphor layer 25 they meet. In contrast thereto, the BSE have intrinsically a higher energy, so that they are able to penetrate to the second phosphor layer 27 and will also excite this layer 27. In this process light of a second wavelength is generated. Instead of opting for a BSE and SE detection medium composed of two different phosphor layers, it is alternatively possible to utilize grains whose jacket is made of a first phosphor and its core of a second phosphor. The light thus generated is thereafter conveyed to a light-splitting element 31, preferably *via* a flexibel optical conductor, which element spatially splits the different wavelengths. In the embodiment the light-splitting element 31 is a prism arranged outside the specimen chamber 3. It is alternatively possible to incorporate the detection system in its totality into the specimen chamber 3. The two different colours of the light can then be detected by separate photomultipliers 33, two electric signals then being obtained, which are determined by the BSE, and by the BSE and SE, respectively. Thereafter, in a signal processing system 35, the two signals of each detector 21 are subtracted from each other to obtain the topographical information. Since an improved image quality can be obtained by adding together the information from a plurality of detectors, by which at the same time inhomogeneity of the field caused by the increased voltage of the detectors 21 are prevented, the signals originating from the several detectors 21 are finally combined and processed into a topographical image in the image processing system 37. If so desired, other types of processing operations can alternatively be performed on the signals. The detector or detectors 21 can alternatively be incorporated in a holder for, for example, the lens system 15.

## Claims

1. An electron beam apparatus including a specimen holder accommodated in a specimen chamber, an electron beam for generating a primary electron beam, by which by interaction with a specimen secondary electrons (SE) and backscattered electrons (BSE) are generable and a detection system for detection and processing of both the secondary electron signal and the backscattered electron signal to form a topographical image, characterized, in that the detection system is arranged for the simultaneous detection of the SE-signal and the BSE-signal, using the same detector.

2. An electron beam apparatus as claimed in Claim 1, characterized, in that, the detection system is arranged for on-line processing of the SE-signal and the BSE-signal.

3. An electron beam apparatus as claimed in Claims 1 and 2, characterized, in that, a detector for detecting both the SE-signal and the BSE-signal is in a BSE-detection position.

4. An electron beam apparatus as claimed in Claims 1-3, characterized, in that, the detector can be adjusted to a higher potential for detection of SE.

5. An electron beam apparatus as claimed in Claims 1-4, characterized, in that, a first end of the detector, which end faces the specimen, has two phosphor layers, a first phosphor layer which emits light at a first wavelength and a second phosphor layer which emits light at a second wavelength.

6. An electron beam apparatus as claimed in Claim 5, characterized, in that, a second end of the detector, facing away from the specimen, includes a light-splitting element for separating the different wavelengths to be detected, light beams having different colours being incident on different ligh-sensitive meters.

7. An electron beam apparatus as claimed in Claims 1-6, characterized, in that, the detection system includes a plurality of detectors arranged symmetrically relative to the optical axis.

8. A method of detecting and processing SE-signals for providing topographical information of a specimen, characterized, in that, both signals are simultaneously detected by one and the same detector, are optically separated from each other and are processed on-line.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 7, no. 280 (E-216)(1425) December 14, 1983 & JP-A-58 158 848 (NIPPON DENSHI K.K. ) September 21, 1983 * the whole document * | 1,2,5,6,8 | H 01 J 37/244 |
| | – – – | | |
| A | US-A-3 896 308   (VENABLES ET AL.) * column 2, line 4 - line 21; figure 1 * | 1,2,4 | |
| | – – – | | |
| D,A | EP-A-0 018 031   (N.V. PHILIPS GLOEILAMPEN-BABRIEKEN) * claim 10; figure 2 * | 7 | |
| | – – – – – | | |

| | | | TECHNICAL FIELDS SEARCHED (Int. Cl.5) |
|---|---|---|---|
| | | | H 01 J |

The present search report has been drawn up for all claims

| Place of search | Date of completion of search | Examiner |
|---|---|---|
| The Hague | 08 October 91 | SCHAUB G.G. |

CATEGORY OF CITED DOCUMENTS
X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document